(19) **Europäisches Patentamt**

**European Patent Office**

**Office européen des brevets**

(11) **EP 1 553 698 A1**

(12) **EUROPEAN PATENT APPLICATION**
published in accordance with Art. 158(3) EPC

(43) Date of publication:
**13.07.2005 Bulletin 2005/28**

(21) Application number: **02760664.9**

(22) Date of filing: **20.08.2002**

(51) Int Cl.⁷: **H03G 3/30**

(86) International application number:
**PCT/JP2002/008362**

(87) International publication number:
**WO 2004/019489 (04.03.2004 Gazette 2004/10)**

(84) Designated Contracting States:
**AT BE BG CH CY CZ DE DK EE ES FI FR GB GR
IE IT LI LU MC NL PT SE SK TR**

(71) Applicant: **MITSUBISHI DENKI KABUSHIKI
KAISHA
Tokyo 100-8310 (JP)**

(72) Inventors:
• **INOUE, Yuji
c/o Mitsubishi Denki Kabushiki Kaisha
Chiyoda-ku, Tokyo 100-8310 (JP)**

• **SHIMIZU, H.
c/o Mitsubishi Denki Kabushiki Kaisha
Chiyoda-ku, Tokyo 100-8310 (JP)**

(74) Representative: **Popp, Eugen, Dr.
MEISSNER, BOLTE & PARTNER
Postfach 86 06 24
81633 München (DE)**

(54) **GAIN CONTROL METHOD, GAIN CONTROLLER, RECEIVER HAVING THE GAIN CONTROLLER, AND MOBILE TELEPHONE**

(57) A gain control method and a gain control device for comparing output power (Wo) of a variable gain amplifier (4) with target power (Wd) and controlling the gain of the variable gain amplifier (4) in accordance with a comparison result, **characterized in that** plural gain control cycles are executed while changing a control gain difference determined as the difference between a gain which has been already set in the variable gain amplifier (4) and a gain which is newly set. According to the present invention, there can be implemented the gain control device and the gain control method for controlling the gain of the amplifier at high speed, and a receiver (1) and a cellular phone which are provided with the gain control device (4).

FIG. 2

EP 1 553 698 A1

**Description**

Technical Field

The present invention relates to a gain control method and a gain control device for controlling the gain of an amplifier, and a receiver and a cellular phone which are equipped with the gain control device.

Background Art

When a prescribed signal is amplified to stabilize variation of reception power, a receiver used in a communication network system uses a "gain control device" for controlling the gain of the amplification. Here, a variable gain amplifier and a portion for controlling the gain of the variable gain amplifier are collectively referred to as "gain control device"). In a receiver using a digital processing type demodulator, an output from a variable gain amplifier equipped to a gain control device is converted to a digital data sequence by anA/D converter equipped to the gain control device, and then input to a digital processing type demodulator.

However, in order to allow the dynamic range of the A/D converter to target the output power in the overall range from the minimum output power output from the variable gain amplifier to the maximum output power, the A/D converter is required to have extremely high performance. However, it is unrealistic to prepare for such an A/D converter, and it is general to use an A/D converter which can treat the output power in a predetermined part of the overall range from the minimum output power output from the variable gain amplifier to the maximum output power.

Accordingly, in such a case, there exists a problem that the power output from the variable gain amplifier must be amplified to a predetermined magnification within a predetermined time.

Here, anAGC circuit disclosed in JP-A-11-289231 has been hitherto known as a device for controlling the gain of a gain amplifier.

According to the conventional AGC circuit, a signal output from a gain amplified equipped to a communication terminal used in a communication system is sorted to one of three areas in accordance with magnitude of power, and a response speed of the AGC circuit is determined on the basis of which one of the areas the output power is sorted to, thereby determining the gain of the gain amplifier.

The response speed of the AGC circuit represents a speed at which the signal passes through the AGC circuit, and there is a characteristic that the quality of the signal output from the AGC circuit is more deteriorated as the response speed is higher.

The present invention has an object to provide a gain control method and a gain control device which can carry out gain control of a variable gain amplifier by a control operation completely different from the prior art at high speed and with high precision.

The present invention proposes a gain control method which is improved so that the time required to adjust the gain can be more shortened by making the gain difference variable and carrying out gain control on the variable gain amplifier.

Furthermore, the present invention proposes a gain control device which is improved so that the time required to adjust the gain can be more shortened by making the gain difference variable and carrying out gain control on the variable gain amplifier.

Still furthermore, the present invention proposes a receiver which uses a gain control device improved so that the gain difference is made variable and the gain adjustment is carried out and in which the magnitude of power input to an A/D converter is within a dynamic range of the A/D converter until a predetermined time elapses from input of a signal to the A/C converter.

Still furthermore, the present invention proposes a cellular phone which uses a gain control device improved so that the gain difference is made variable and the gain adjustment is carried out and in which the magnitude of power input to an A/D converter is within a dynamic range of the A/D converter until a predetermined time elapses from input of a signal to the A/C converter.

Disclosure of Invention

According to the present invention, there is provided a gain control method for comparing output power of a variable gain amplifier with predetermined target power and controlling the gain of the variable gain amplifier in accordance with a comparison result, which can execute plural gain control cycles while changing the control gain difference thereof.

In the above gain control method of the present invention, the control gain difference at each gain control cycle is successively reduced in connection with the repetition of the gain control cycle.

In the above gain control method of the present invention, the control gain difference at each gain control cycle is successively reduced by half in connection with the repetition of the gain control cycle.

In the above gain control method of the present invention, the gain control cycle includes a gain difference calculating step of calculating the gain difference between the gain set in the variable gain amplifier and a gain which is to be next set, and a gain setting step of setting the gain of the variable gain amplifier in accordance with the calculation result of the gain difference calculating step.

The above gain control method of the present invention contains a recovery operation of retrying the gain control when the gain control falls into a state that the gain to the variable gain amplifier cannot be converged into a predetermined control width.

In the above gain control method of the present invention, the number of the gain control cycles can be set.

In the gain control method of the present invention, the control gain difference at each gain control cycle is determined as the difference between a gain which has been already set in the variable gain amplifier and a gain which is newly set.

In the above gain control method of the present invention, a gain when the output of the variable gain amplifier reaches a predetermined target value in the previous operation of the variable gain amplifier is used as a gain which is initially set in the variable gain amplifier.

According to the present invention, there is provided a gain control method for comparing output power of a variable gain amplifier with predetermined target power and controlling the gain of the variable gain amplifier in accordance with a comparison result, and comprises a first gain control operation of executing plural gain control cycles while varying the control gain difference thereof, and a second gain control operation of executing plural gain control cycles while the control gain difference thereof is fixed.

In the gain control method of the present invention, the gain control cycles of the first gain control operation are executed while varying each gain control difference thereof.

In the above gain control method of the present invention, the control gain difference at each gain control cycle in the first gain control operation is successively reduced in connection with the repetition of the gain control cycle.

In the gain control method of the present invention, the control gain difference at each gain control cycle in the first gain control operation is successively reduced by half in connection with the repetition of the gain control cycle.

In the above gain control method of the present invention, the gain control cycle of the first gain control operation includes a gain difference calculating step of calculating the gain difference between a gain set in the variable gain amplifier and a gain to be next set, and a gain setting step of setting the gain of the variable gain amplifier in accordance with the calculation result of the gain difference calculating step.

The above gain control method of the present invention further comprises a recovery operation of retrying the gain control when the gain control falls into a state that the gain to the variable gain amplifier cannot be converged into a predetermined control width in the first gain control step.

In the above gain control method of the present invention, the number of the gain control cycles in the first gain control step can be set.

In the above gain control method of the present invention, after the first gain control operation is finished, the second gain control operation is carried out.

In the above gain control method of the present invention, during a period when the second gain control operation is carried out, the second gain control operation is switched to the first gain control operation on the basis of a predetermined condition.

In the above gain control method of the present invention, the second gain control operation includes a judging step of judging on the basis of detected power whether the first gain control operation should be executed or not.

In the above gain control method of the present invention, the control gain difference at each gain control cycle in the first gain control operation is determined as the difference between a gain which has been already set in the variable gain amplifier and a gain which is newly set.

In the above gain control method of the present invention, in the first gain control operation, a gain when the output of the variable gain amplifier reaches a predetermined target value in the previous operation of the gain amplifier is used as the gain which is initially set in the variable gain amplifier.

According to the present invention, there is provided a gain control device for comparing output power of a variable gain amplifier with predetermined target power and controlling the gain of the variable gain amplifier in accordance with a comparison result, which can execute plural gain control cycles while changing the control gain difference thereof.

In the above gain control device of the present invention, the control gain difference at each gain control cycle is successively reduced in connection with the repetition of the gain control cycle.

In the above gain control device of the present invention, the control gain difference at each gain control cycle is successively reduced by half in connection with the repetition of the gain control cycle.

In the above gain control device of the present invention, the gain control cycle is set to carry out a gain difference calculating step of calculating the gain difference between the gain set in the variable gain amplifier and a gain which is to be next set, and a gain setting step of setting the gain of the variable gain amplifier in accordance with the calculation result of the gain difference calculating step.

In the above gain control device of the present invention, the gain control contains a recovery operation of retrying the gain control when the gain control falls into a state that the gain to the variable gain amplifier cannot be converged into a predetermined control width.

In the above gain control device of the present invention, the number of the gain control cycles can be set.

In the gain control device of the present invention, the control gain difference at each gain control cycle is determined as the difference between a gain which has been already set in the variable gain amplifier and a gain which is newly set.

In the above gain control device of the present invention, a gain when the output of the variable gain amplifier reaches a predetermined target value in the previous operation of the variable gain amplifier is used as a gain which is initially set in the variable gain amplifier.

According to the present invention, there is provided a gain control device for comparing output power of a variable gain amplifier with predetermined target power and controlling the gain of the variable gain amplifier in accordance with a comparison result, and is designed so that the gain control cycle is set to carry out a first gain control operation of executing plural gain control cycles while varying the control gain difference thereof, and a second gain control operation of executing plural gain control cycles while the control gain difference thereof is fixed.

In the gain control device of the present invention, the gain control cycles of the first gain control operation are executed while varying each gain control difference thereof.

In the above gain control device of the present invention, the control gain difference at each gain control cycle in the first gain control operation is successively reduced in connection with the repetition of the gain control.cycle.

In the gain control device of the present invention, the control gain difference at each gain control cycle in the first gain control operation is successively reduced by half in connection with the repetition of the gain control cycle.

In the above gain control device of the present invention, the gain control cycle of the first gain control operation is set to carry out a gain difference calculating operation of calculating the gain difference between a gain set in the variable gain amplifier and a gain to be next set, and a gain setting operation of setting the gain of the variable gain amplifier in accordance with the calculation result of the gain difference calculating operation.

In the above gain control device of the present invention, the first gain control operation contains a recovery operation of retrying the gain control when the gain control falls into a state that the gain to the variable gain amplifier cannot be converged into a predetermined control width in the first gain control operation.

In the above gain control device of the present invention, the number of the gain control cycles in the first gain control operation can be set.

In the above gain control device of the present invention, after the first gain control operation is finished, the second gain control operation is carried out.

In the above gain control device of the present invention, during a period when the second gain control operation is carried out, the second gain control operation is switched to the first gain control operation on the basis of a predetermined condition.

In the above gain control device of the present invention, the second gain control operation contains a judging step of judging on the basis of detected power whether the first gain control step should be executed or not.

In the above gain control device of the present invention, the control gain difference at each gain control in the first gain control operation is determined as the difference between a gain which has been already set in the variable gain amplifier and a gain which is newly set.

In the above gain control device of the present invention, in the first gain control operation, a gain when the output of the variable gain amplifier reaches a predetermined target value in the previous operation of the gain amplifier is used as the gain which is initially set in the variable gain amplifier.

According to the invention, there is provided a receiver equipped with the gain control device.

Further, according to the invention, there is provided a cellular phone equipped with the gain control device.

According to the present invention, there can be implemented the gain control method in which the control gain difference is controlled to be variable in each gain control cycle, so that the gain control speed and the gain control precision can be set to optimal values.

According to the present invention, the gain control precision is enhanced in connection with the repetition of the gain control cycle, and thus there can be implemented the gain control method for carrying out the gain control so that the gain to the variable gain amplifier is quickly converged into a predetermined width.

According to the present invention, the recovery operation is provided, and thus there can be implemented the gain control method for preventing that the gain to the variable gain amplifier cannot be converged into a predetermined width.

According to the present invention, the repetition cycle of the gain control cycle can be set, and thus there can be implemented the gain control method in which the gain control speed and the gain control precision can be arbitrarily selected.

According to the present invention, the gain when the output of the variable gain amplifier reaches a predetermined target value in the previous operation of the variable gain amplifier can be used, and thus there can be implemented the higher-speed gain control method when the convergence of the gain is limited to a specific range.

According to the present invention, even when the second gain control step in which the control gain difference of each gain control cycle is fixed is carried out, it can be returned to the first gain control step in which the control gain difference of each gain control cycle is variable, and then the gain control is carried out. Therefore, there can be implemented the gain control method which can quickly perform the gain control when the gain control of a large width is needed during the operation of the gain control step in which the control gain difference of each gain control cycle is fixed.

According to the present invention, when the output of the variable gain amplifier does not exist within the dynamic range of the A/D converter even during the operation of the second gain control step in which the gain control difference of each gain control cycle is fixed, the second gain control step can be returned to the first gain control step in which the control gain difference of each gain control cycle is variable, and the gain control is carried out. Therefore, there can be implemented the gain control method in which a state that a demodulator cannot be properly actuated an be quickly dissolved.

According to the present invention, the control gain difference is controlled to be variable in each gain control cycle, and thus there can be implemented the gain control device in which the gain control speed and the gain control precision required to each gain control cycle is optimally set.

According to the present invention, the gain control precision is enhanced in connection with the repetition of the gain control cycle, and thus there can be implemented the gain control device for carrying out the gain control so that the gain to the variable gain amplifier is quickly converged into a predetermined width.

According to the present invention, the recovery operation is provided, and thus there can be implemented the gain control device which can prevent that the gain to the variable gain amplifier cannot be converged into a predetermined width.

According to the present invention, since the repetition frequency of the gain control cycle can be set, and thus there can be implemented the gain control device in which the gain control speed and the gain control precision can be arbitrarily selected.

According to the present invention, when the gain when the output of the variable gain amplifier reaches a predetermined target value in the previous operation of the variable gain amplifier can be used, and thus there can be implemented the higher-speed gain control device when the convergence of the gain is limited to a specific range.

According to the present invention, even during the second gain control operation in which the control gain difference of the gain control cycle is fixed is carried out, the second gain control operation is returned to the first gain control operation in which the control gain difference of each gain control cycle is variable, and the gain control is carried out. Therefore, there can be implemented the gain control device in which the gain control is carried out at high speed when gain control having a large width is needed during the gain control operation in which the control gain difference of the gain control cycle is fixed.

According to the present invention, when the output of the variable gain amplifier does not exist in the dynamic range of the A/D converter during the second gain control operation in which the control gain difference of the gain control cycle is fixed, the second gain control operation is returned to the first gain control operation in which the control gain difference of each gain control cycle is variable, and then the gain control is carried out. Therefore, there can be implemented the gain control device in which the state that the demodulator is not properly actuated can be dissolved.

According to the present invention, the control gain difference in the gain control cycle is controlled to be variable. Therefore, there can be implemented the receiver in which the gain control speed and the gain control precision required to each gain control cycle is optimally set.

According to the present invention, the gain control precision is enhanced in connection with the repetition of each gain control cycle, and thus there can be implemented the receiver for quickly carrying out the gain control so that the gain to the variable gain amplifier is converged into a predetermined width.

According to the present invention, the recovery operation is provided, and thus there can be implemented the receiver which prevents that the gain to the variable gain amplifier cannot be converged into a predetermined width.

According to the present invention, the repetition frequency of the gain control cycle can be set, and thus there can be implemented the receiver in which the gain control speed and the gain control precision can be arbitrarily selected.

According to the present invention, there can be implemented the receiver in which the gain when the output of the variable gain amplifier reaches a predetermined target value in the previous operation of the variable gain amplifier can be used, and thus there can be implemented the higher-speed receiver when the convergence of the gain is limited to a specific range.

According to the present invention, even during the second gain control operation in which the gain control difference of the gain control cycle is fixed, the second gain control operation is returned to the first gain control operation in which the control gain difference of each gain control cycle is variable, and then the gain control is carried out. Therefore, there can be implemented the receiver which can the gain control at high speed when the gain control having a large width is needed during the gain control operation in which the control gain difference of the gain control cycle is fixed.

According to the present invention, when the output of the variable gain amplifier does not exist within the dynamic range of the A/D converter even during the second gain control operation in which the control gain difference of the gain control cycle is fixed, the second gain control operation is returned to the first gain control operation in which the control gain difference of the gain control cycle is variable, and then the gain control is carried out. Therefore, there can by implemented the receiver in which the state that the demodulator is not properly actuated is quickly dissolved.

According to the present invention, the control gain difference in the gain control cycle is controlled to be variable, and thus there can be implemented the cellular phone in which the gain control speed and the gain control precision required to the gain control cycle can be optimally set.

According to the present invention, the gain control precision is enhanced in connection with the repetition of each gain control cycle, and thus there can be implemented the cellular phone in which the gain control is carried out so that the gain to the variable gain amplifier is quickly converged into a predetermined width.

According to the present invention, the recovery operation is provided, and thus there can be implemented the cellular phone in which it can be prevented that the gain to the variable gain amplifier cannot be converged into a predetermined width.

According to the present invention, the repetition frequency of the gain control cycle can be set, and thus there can be implemented the cellular phone in which the gain control speed and the gain control precision can be arbitrarily selected.

According to the present invention, the gain when the output of the variable gain amplifier reaches a predetermined target value in the previous operation of the variable gain amplifier can be used, and thus there can be implemented the higher-speed cellular phone when the convergence of the gain is limited to a specific range.

According to the present invention, even during the second gain control operation in which the control gain difference of the gain control cycle is fixed, the second gain control operation is returned to the first gain control operation in which the control gain difference of the gain control cycle is variable, and then the gain control is carried out. Therefore, there can be implemented the cellular phone which carries out the gain control at high speed when the gain control of a large width is needed during the gain control operation in which the gain difference of the gain control cycle is fixed.

According to the present invention, when the output of the variable gain amplifier does not exist within the dynamic range of the A/D converter even during the second gain control operation in which the control gain difference of the gain control cycle is fixed, the second gain control operation is returned to the first gain control operation in which the control gain difference of the gain control cycle is variable, and then the gain control is carried out. Therefore, there can be implemented the cellular phone in which the state that the demodulator is not properly actuated can be quickly dissolved.

Brief Description of the Drawings

Fig. 1 is a diagram showing a receiver containing a gain control device according to an embodiment 1 of the present invention.
Fig. 2 is a flowchart showing the operation of a gain controller according to the embodiment 1.
Fig. 3 is a diagram showing a gain control operation.
Fig. 4 is a diagram showing a gain control operation.
Fig. 5 is a diagram showing the construction of a gain controller according to an embodiment 2.
Fig. 6 is a flowchart showing the operation of the gain controller of the embodiment 2.
Fig. 7 is a flowchart showing the operation of a gain controller according to an embodiment 4.
Fig. 8 is a diagram showing the relationship between a predetermined frequency N and gain control precision.
Fig. 9 is a flowchart showing the operation of an embodiment 5.

Best Modes for Carrying out the Invention

Embodiment 1

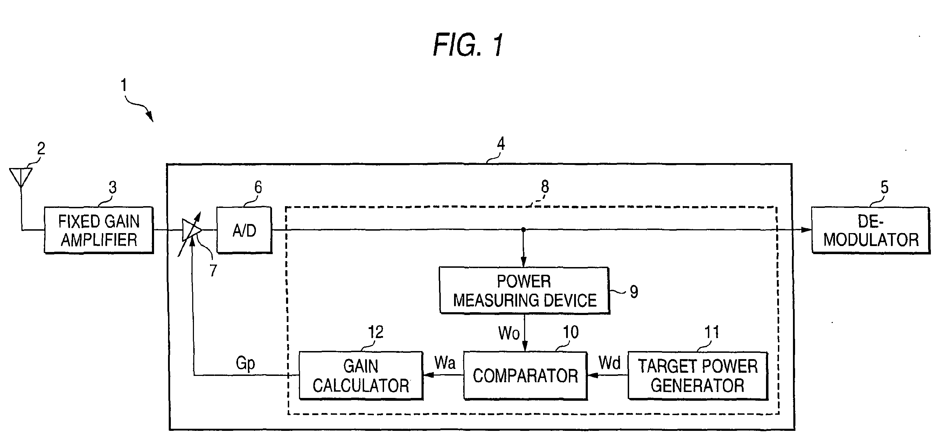

Fig. 1 is a diagram showing the construction of a receiver of a cellular phone containing a gain control device according to an embodiment 1 of the present invention. The receiver carries out intermittent reception in accordance with an operation of the cellular phone, and an intermission state exists between respective reception states.

First, the construction of an embodiment 1 of the present invention will be described with reference to Fig. 1.

In Fig. 1, reference numeral 1 represents a receiver containing a gain control device of the present invention, reference numeral 2 represents an antenna for receiving a radio signal, reference numeral 3 represents a fixed gain amplifier for amplifying a signal received by the antenna 2 at a fixed gain, and reference numeral 4 represents a gain control device constituting a main part of the invention, which carries out gain control on an amplified output signal of the fixed gain amplifier 3 and outputs an output signal having desired output power. Reference numeral 5 represents a demodulator, and reference numeral 6 represents an A/D converter, and the output signal of the gain control device 4 is supplied to the demodulator 5 through the A/D converter 6, and demodulated there.

The gain control device 4 is equipped with a variable gain amplifier 7 and a gain controller 8 in addition to the A/D converter 6. The gain controller 8 has a power measuring portion 9, a comparator 10, a target power generator 11 and a gain calculator 12, and it carries out a control cycle at a frequency of (N+M) (N, M represents an integer of 1 or more) under each reception state which is intermittently repeated, thereby carrying out an operation of successively approaching detected power Wo to target power Wd. After the detected power Wo is approached to the target power Wd, the state that the detected power Wo is being approached to the target power Wd is kept.

The power measuring portion 9 is connected to the output portion of the A/D converter 6, and receives a signal achieved by converting an output signal of the variable gain amplifier 7 to a digital signal by the A/D converter 6 to measure the output power of the output signal of the variable gain amplifier 7 every control cycle and generate the detected power Wo. A target power generator 11 outputs as a digital value the target power Wd corresponding to the power value to be controlled. The comparator 10 serves as comparing means, and it digitally compares the detected power Wo from the power measuring portion 9 with the target power Wd from the target power generator 11 every control cycle and supplies the power difference Wa (Wo - Wd) to the gain calculator 12. The gain calculator 12 comprises a microcomputer, and it carries out a predetermined calculation on the basis of the power difference Wa every control cycle to generate a gain control voltage Gp and supply it to the variable gain amplifier 7. The variable gain amplifier 7 sets the gain on the basis of the gain control voltage Gp every control cycle, and carries out the amplification corresponding to the gain thus set.

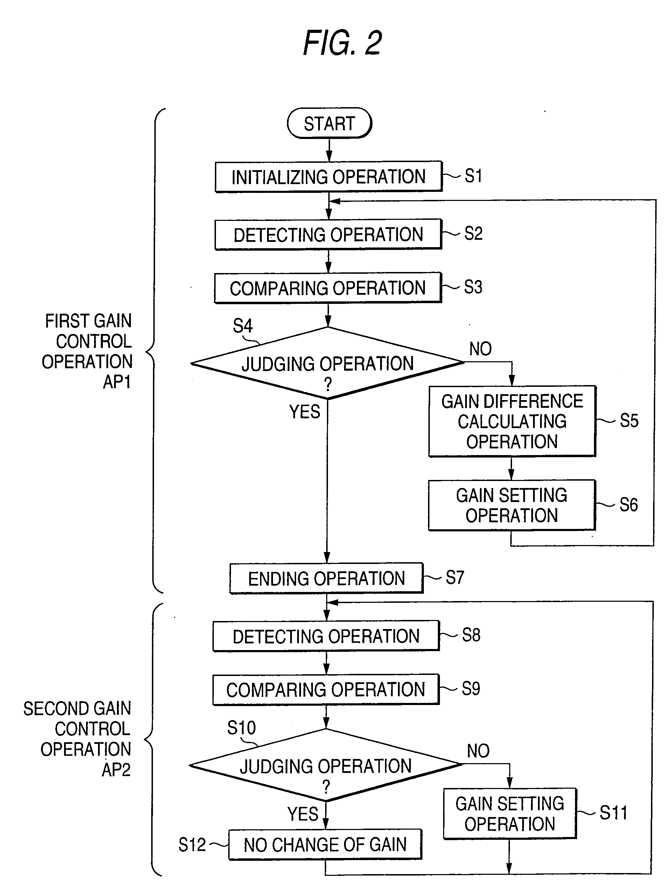

Fig. 2 is a flowchart showing the operation of the gain controller 8, and shows the gain control method according to the embodiment 1. The operation of the gain controller 8 will be described with reference to Fig. 2. The gain controller 8 executes a first gain control operation AP1 and a subsequent second gain control operation AP2.

First, the first gain control operation AP1 will be described. The first gain control operation AP1 executes the gain control cycle at N times (N represents an integer of 1 or more).

First, it is assumed that an initial gain Gp0 and an initial gain difference Gv0 to the variable gain amplifier 7 are not set under an initial state.

Step S1 is a step of carrying out an initializing operation, and initially sets the initial gain Gp0 and the initial gain difference Gv0 to the variable gain amplifier 7. The values of the initial gain Gp0 and the initial gain difference Gv0 are held in the gain calculator 12. The initial gain Gp0 and the initial gain difference Gv0 may be set to values independent on each other, however, in this case, it is assumed that when the initial gain Gp0 is set, the initial gain difference Gv0 can be set by directly using the above value. If it is represented by an equation, it could be represented by the following equation (1).

$$Gp0 = Gv0 \qquad (1)$$

The initialization work can be quickly performed by setting the initial gain Gp0 and the initial gain Gv0 interlockingly with each other. The initial gain Gp0 is assumed to be set to the center value Rm in the dynamic range of the variable gain amplifier 7, that is, the input range to the variable gain amplifier in which the variable gain amplifier 7 can be properly actuated. For example, when the variable gain amplifier 7 has the dynamic range from 0 (dB) to 100 (dB), the initial gain Gp0 is set to 50 (dB). As the initial gain Gp0 may be used a gain value when the power Wo output from the variable gain amplifier 7 is converged to the target power Wd under the previous reception state. By using such a value, the gain control can be performed at higher speed when the convergence of the gain is limited to a specific range.

As shown in the equation (1), the value of the initial value Gp0 is directly used as the initial gain difference Gv0. For example, in the case of the initial gain Gp0 = 50dB, the initial gain difference Gv0 is set to 50dB.

Step S2 is a step of detecting the detected power Wo by the power measuring device 9, and it detects the detection power Wo in each control cycle. Under the initial state, the output power Wo of the variable gain amplifier which corresponds to the initial gain Gp0 set in the initializing operation of the step S1 is detected. When another gain is set in a step described later, the output power Wo of the variable gain amplifier 7 which corresponds to the gain thus set is detected.

Step S3 is a step of carrying out a comparing operation, and the power difference Wa between the detected power Wo measured in step S2 and the target power Wd output from the target power generator 11 is calculated by the comparator 10. The equation used in this case is represented by the following equation (2).

$$Wa = Wo - Wd \tag{2}$$

Step S4 is a step concerning a judgment operation, and it is judged whether the absolute value of the power difference Wa calculated by the comparator 10 in step S3 is equal to, smaller than or larger than a threshold value Wp (threshold value Wp is assumed to be a positive number). When the absolute value of the difference Wa calculated by the comparator 10 is equal to or smaller than the threshold value Wp, the detected power Wo exists in the area between the first lower limit value Lmin1 and the first upper limit value Lmax1 (hereinafter referred to as first area), and thus this state will be hereinafter referred to as "in-first-area state"). Furthermore, when the absolute value of the power difference Wa calculated by the comparator 10 is larger than the threshold value Wp, the detected power Wo does not exist in the first area, and thus this state will be hereinafter referred to as "out-of-first-area state"). When this is represented by equations, the following equations (3) and (4) are provided:

For |Wa|≤Wp,

$$Lmin1 \leq Wo \leq Lmax1$$

$$\text{(in-first-area state)} \tag{3}$$

For |Wa| > Wp,

$$Wo < Lmin1, Wo > Lmax1$$

$$\text{(out-of-first-area state)} \tag{4}$$

In step S4, in the case of the "out-of-first-area state" , it is judged whether the present state is a state where the power difference Wa is a positive value or a state where it is negative value. Here, under the state that the power difference Wa is a positive value in the case of the "out-of-first-area state", the power difference Wa exceeds the first upper limit value Lmax1, and thus this state will be hereinafter referred to as "first-upper-limit over state". Under the state that the power difference Wa is a negative value in the case of the out-of-first-area state, the power difference Wa is further smaller than the first lower limit value Lmin1, and thus this state will be hereinafter referred to as "first-lower-limit over state".

When the subtraction of the equation (2) is inversely taken and the equation thus achieved is used as the following equation (5) in the comparator 10, the state that the power difference Wa is a positive value in the case of the "out-of-first-area state" may be referred to as "first-lower-limit over state", and the state that the power difference Wa is a negative value in the case of the "out-of-first-area state" may be referred to as "first-upper-limit over state".

$$Wa = Wd - Wo \tag{5}$$

Step S5 corresponds to a gain difference calculating operation started when the judgment result in the judgment step S4 is the "out-of-first-area state". In the gain difference calculating operation of the step S5, a gain difference Gvn which is set at present is calculated in the variable gain amplifier 7. Specifically, as shown in the equation (6), when the previously set gain difference is represented by Gvn-1, the gain difference Gvn which is set at present is calculated as the absolute value of a half value of the gain difference Gvn-1. For example, when the presently set gain difference Gvn is a gain difference calculated subsequently to the initial gain difference Gv0, the gain difference Gvn is equal to the absolute value of a half value of the initial gain difference Gv0.

$$Gvn = |(1/2)Gvn\text{-}1| \ (n \neq 0) \tag{6}$$

Step S6 is a step for a gain setting operation started after the gain difference Gvn is calculated through the gain difference calculating operation in step S5.

In this step S6, it is first determined whether the gain difference Gvn calculated in the gain difference calculating operation of the step S5 is a positive value or negative value. The result of the judgment operation of the step S4 is used for this determination, and if the power difference Wa is positive, the gain difference Gvn is set to a negative value because the state is "first-upper-limit over state". If the power difference Wa is negative, the gain difference Gvn is set to a positive value because the state is "first-lower-limit over state".

Subsequently, the gain Gpn which is set at present is calculated in the variable gain amplifier 7 by using the gain difference Gvn whose sign is settled, and the calculation result is set in the variable gain amplifier 7. As shown in the following equations (8) (10), the gain Gpn set at present is calculated by adding the gain Gpn-1 set previously in the variable gain amplifier 7 with the gain difference Gpn whose sign is settled. The presently set gain Gvn is calculated by the equation (8) under the "first-upper-limit over state" in which the power difference Wa is positive, or by the equation (10) under the "first-lower-limit over state" in which the power difference Wa is negative. The initial gain difference Gp0 is set to the center value Rm of the dynamic range of the variable gain amplifier 7 as shown in the equation (9).

In the case of "first-upper-limit over state" (Wa>0),

$$Gpn = Gpn\text{-}1 - Gvn \quad \text{(n represents a natural number)} \tag{8}$$

$$Gp0 = Rm \tag{9}$$

In the case of "first-lower-limit over state" (Wa<0),

$$Gpn = Gpn\text{-}1 + Gvn \quad \text{(n represents a natural number)} \tag{10}$$

$$Gp0 = Rm \tag{9}$$

Step S7 is a step for an ending operation started when the judgment result of step S4 indicates "in-first-areas state". When the step S7 of the ending operation is started, the first gain control operation AP1 is finished.

The first gain control operation AP1 executes the gain control cycle at N times (N is equal to zero or represents an integer of 1 or more). If the initial gain Gp0 which is initially set in the first step S1 exists within the control width of the first gain control operation AP1, the first gain control operation AP1 immediately goes from step S4 to step S7 without executing the gain setting operation of the steps S5, S6 in the first gain control cycle, and then finishes the operation. However, such a case occurs extremely rarely. In general, the gain control cycle is repeated at two or more times until the detected power Wo is converged into the control width of the target power Wd based on the first gain control operation AP1. If the detected power Wo is converged into the control width of the target power Wd in the first gain control cycle, the gain control cycle of the first gain control operation is finished at the second time. However, if the detected power Wo is not converged into the control width of the target power Wd by the first gain control, the second gain control cycle is executed, and the gain control cycle is likewise repetitively executed in the first gain control operation AP1 until the detected power Wo is converged into the control width of the target power Wd.

If the first gain control operation AP1 is finished, the second gain control operation AP2 is started. The second gain control operation AP2 is an operation of further approaching the detected power Wo to the target power Wd by the control cycle of M times (M represents an integer of 1 or more) using a fixed gain difference Gvc.

With respect to the second gain control operation AP2, step S8 is a step for executing a detection operation. When the second gain control operation AP2 is started, this step is first started, and the output power from the variable gain amplifier 7 is newly measured by the power measuring device 9, thereby outputting the detected power Wo.

Step S9 is a step for executing a comparing operation. The detected power Wo is newly compared with predetermined target power Wd by the comparator 10, and the power dif f erence Wa (Wo-Wd) thereof is calculated.

Step S10 is a step of executing a judgment operation, and it is judged whether the absolute value of the power difference Wa calculated in the comparator 10 is larger than a threshold value Wq. Under the state that the absolute value of the power difference Wa calculated in the comparator 10 is equal to or smaller than the threshold value Wq, the detected power Wo exists in a second area from the second lower limit value Lmin2 to the second upper limit Lmax2, and thus this state will be hereinafter referred to as "in-second-area state". Under the state that the absolute value of the power difference Wa calculated in the comparator is larger than Wq, the detected power Wo does not exist in the second area, and thus this state will be hereinafter referred to as "out-of-second-area state". The threshold value Wq used in this step S10 is set to a smaller value as compared with the threshold value Wp used in the judgment operation of the step S4. If the judgment operation of the step S10 is represented by equations, the following equations (11) (12) are provided.

For |Wa|≤Wq,

$$Lmin2 \le Wo \le Lmax2$$

$$\text{(in-second-area state)} \tag{11}$$

For |Wa| > Wq,

$$Wo < Lmin2, Wo > Lmax2$$

$$\text{(out-of-second-area state)} \tag{12}$$

here, Wq < Wp

Step S11 is a step of executing a gain setting operation. This step is started when the judgment result in the judgment operation of step S10 is the "out-of-second-area state", and sets a new gain Gpn in the variable gain amplifier 7 at present. In the gain setting operation of the step S11, when the previous gain set in the variable gain amplifier 7 is represented by Gpn-1, the gain Gpn-1 is added with a fixed gain difference Gvc (Gvc is not a negative number). However, a positive or negative sign is added to the fixed gain difference Gvc to be added as follows. That is, as in the case of the judgment operation of step S4, when "second-upper-limit over state" is judged in the judgment operation of the step S8, the negative sign is applied to the fixed gain difference Gvc. On the other hand, when "second-lower-limit over state" is judged, the positive sign is applied. The positive or negative sign is added to thereby calculate the presently-set gain Gpn. If it is represented by equations, the following equations (13) (14) are provided.

In the case of "second-upper-limit state",

$$Gpn = Gpn\text{-}1 - |Gvc| \tag{13}$$

In the case of "second-lower-limit state",

$$Gpn = Gpn\text{-}1 + |Gvc| \tag{14}$$

The second gain control operation AP2 executes the control cycle of M times (M represent an integer of 1 or more). When the final gain set value by the first gain control operation AP1 is within the control width of the target power Wd by the second gain control operation AP2, the processing goes to step S12. The second gain control operation AP2 returns to step S8 without executing the gain control operation of step S11 in the first control cycle, and the second gain control operation AP2 repeats the control cycle thereof. However, such a case occurs extremely rarely. In many cases, the final gain set value by the first gain control operation AP1 is out of the control width of the target power Wd by the second gain control operation AP2, so that the gain is set in step S11 and then the detection operation S8 is carried out.

The receiver 1 continues to execute the operation of the steps S8 to S12 insofar as it receives signals.

Subsequently, the first gain control operation AP1 and the second gain control operation AP2 shown in Fig. 2 will be described.

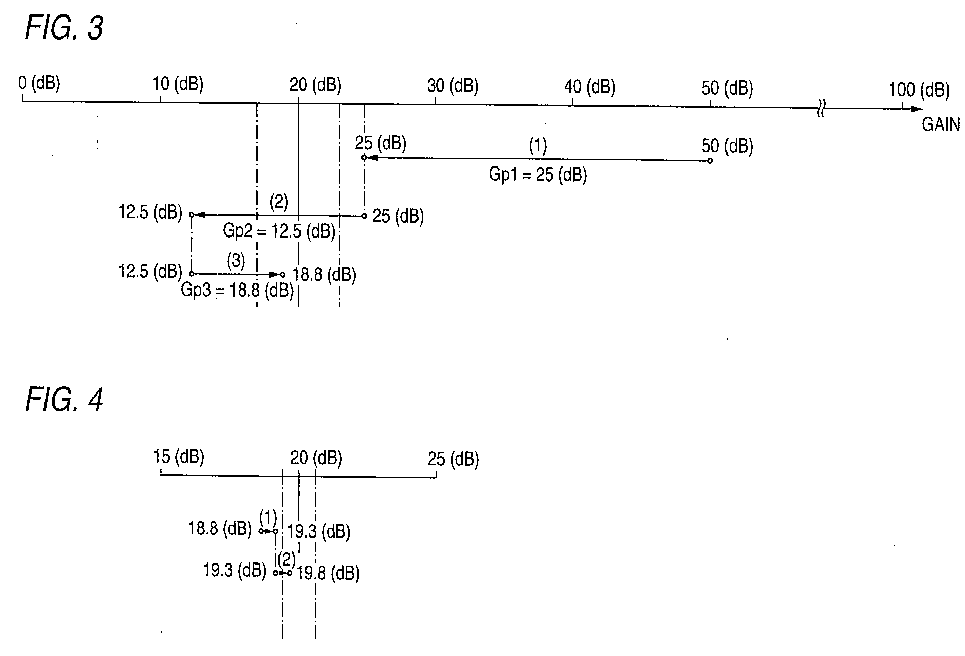

First, the first gain control operation AP1 will be described with reference to Fig. 3. In Fig. 3, the first gain control operation AP1 repeats the gain control cycle at four times.

Fig. 3 is a diagram showing the first gain control operation with specific gain values.

An example of Fig. 3 is based on the assumption that the target power Wd is equal to 20(dB) and the first gain control operation AP1 repeats the gain control cycle until the detected power Wo is converged into the control width of 20±3(dB). Accordingly, it is assumed that if the gain set in the variable gain amplifier 7 is within 20±3(dB), the power Wo output from the variable gain amplifying 7 would be within the first area. With respect to the gain, two or subsequent places after the decimal point are rounded off.

<First control cycle (1)>

When the initial gain Gp0 is initially set to 50(dB), the initial gain difference Gv0 is initially set to 50(dB) from the equation (1) (step S1). Here, the variable gain amplifier 7 outputs power on the basis of the initially set initial gain Gp0. The power Wo thus output is measured by the power measuring device 9 (step S2), and the power difference Wa between the detected power Wo and the target power Wd generated from the target power generator 11 is calculated (step S3). It is assumed that |Wa| is larger than the threshold value Wp and Wo is larger than Wp. In this case, "out-of-first-area state" is judged in the judgment operation of step S4 , and thus the gain difference calculating operation of step S5 is started. In this case, the "first-upper-limit over state" is judged in step S4. In the gain difference calculating operation of step S5, the gain difference Gv1 = 25(dB) is calculated from the equation (6) and the previous gain value Gv0=50(dB). Thereafter, the gain setting operation of the step S6 is started, the gain Gp1=25(dB) is calculated from the equation (8), and the gain Gp1=25(dB) is set in the variable gain amplifier 7.

<Second gain cycle>

The detection power Wo is likewise detected in connection with the variable gain amplifier 7 in which the gain Gp1=25(dB) is set (step S2), the detected power Wo is compared with the target power Wd (step S3), and the judgment operation of the step S4 is started on the basis of the comparison result. In the judgment of the step S4, when the gain Gp1 is set in the variable gain amplifier 7, "out-of-first-area state" is judged from the above assumption. Furthermore, since "first-upper-limit over state" is also judged, the gain difference calculating operation of the step S5 is started again, and the gain difference Gv2=12.5(dB) is calculated from the equation (6) and Gv1. Subsequently, in step S6, the gain Gp2=12.5(dB) is calculated from the calculation result of the step S5 and the equation (8), and the gain Gp2 thereof is set in the variable gain amplifier 7.

<Third control cycle (3)>

The output signal power Wo of the variable gain amplifier 7 in which the gain Gp1=12.5(dB) is set is likewise measured, and the detected power Wo is output (step S2). The detected power Wo and the target power Wd are compared with each other (step S3), and the judgment operation of the step S4 is carried out from the comparison result. In this judgment operation, the detected power Wo of the variable gain amplifier 7 in which the gain Gp2 is set is judged as "out-of-first-area state" from the above assumption, and also "first-lower-limit over state" is judged. Accordingly, the gain difference calculating operation of the step S5 is re-started, and the gain difference Gv3=6.3(dB) is calculated from the equation (6) and Gv2. In the step S6, the gain Gp3=18.8(dB) is calculated from the calculation result of the step S5 and the equation (10), and thus the gain Gp3 is set in the variable gain amplifier 7.

<Fourth control cycle (4)>

The power Wo from the variable gain amplifier 7 in which the gain Gp3=18.8(dB) is set is likewise measured (step S2), the detected power Wo is compared with the target power Wd (step S3), and the judgment operation of the step S4 is started on the basis of the comparison result. In this judgment operation, "in-first-area state" is judged from the above assumption. When "in-first-area state" is judged, the gain control of the steps S5, S6 is not executed, the ending operation of the step S7 is carried out, the first gain control operation AP1 is finished, and the second gain control operation AP2 is started.

Next, the second gain control operation will be described. The second gain control operation AP2 is operated so that the output power Wo of the variable gain amplifier 7 is approached to the target power with higher precision as compared with the first gain control operation AP1.

Fig. 4 is a diagram showing the second gain control operation AP2 with specific numerical values of the gain. Fig. 4 shows an example in which the gain control cycle is repetitively executed in the second gain control operation AP2.

<First control cycle (1)>

As a specific assumption of the second control operation AP2, the control is carried out so that the detected power Wo is converged into the control width of 20±0.5(dB) with respect to the target power 20 (dB). Accordingly, if the gain set in the variable gain amplifier 7 is within 20±0.5(dB), the signal power Wo output from the variable gain amplifier 7 would be judged to be within the second area.

By the fourth control cycle (4) of the first gain control operation AP1 shown in Fig. 3, the gain Gp3 is set to 18.8(dB), and when the second gain control operation AP2 is started, the signal power Wo of the variable gain amplifier 7 is measured on the basis of the gain Gp3 thus set by the power measuring device 9 (step S8), and the power difference Wa between the detected power Wo and the target power Wd generated from the target power generator 11 is calculated (step S9). It is assumed that |Wa| is larger than the threshold value Wq and Wo is larger than Wq. In this case, "out-of-second-area state" is judged in the judgment operation of the step S10, and thus the gain setting operation of the step S11 is started. Furthermore, in this case, "second-lower-limit state" is judged. Here, when the fixed gain difference Gvc is equal to 0.5(dB), the gain Gp4 which is set in the variable gain amplifier 7 at present is equal to 19.3(dB) from the equation (14) and the gain Gp3 set previously in the variable gain amplifier 7.

<Second control cycle (2)>

The variable gain amplifier 7 in which the gain Gp4=19.3(dB) is set is likewise subjected to the gain control, and thus Gp5 is equal to 19.8dB.

<Third control cycle (3)>

The output signal power Wo of the variable gain amplifier 7 in which the gain Gp5=19.8(dB) is set is judged as being under the "in-second-area state" in the judgment operation of the step S8. In this case, the operation returns to the detecting operation without carrying out the gain control of the step S11.

<Fourth control cycle (4)>

The output signal power Wo of the variable gain amplifier 7 in which the gain Gp5=19.8(dB) is set in the third control cycle (3) is judged as being under the "in-second-area state" in the judgment operation of the step S8, and thus no gain setting is carried out.
Accordingly, the gain set in the variable gain amplifier 7 in the fourth control cycle satisfies Gp6=19.8(dB).

<Fifth control cycle (5) and subsequent cycles>

If the reception state of the receiver 1 is not varied, the power Wo of the signal output from the variable gain amplifier 7 in the fourth control cycle (4) would be judged as being under the "in-second-area state" in the judgment operation of the step S8 by setting the gain Gp6=19.8 in the variable gain amplifier 7. However, if the reception state of the receiver is varied, the power Wo of the signal output from the variable gain amplifier 7 would be varied. Accordingly, even when the set gain of the variable gain amplifier 7 satisfies Gp6=19.8 (dB), there may occur a case where the output signal power Wo of the variable gain amplifier 7 is not under the "in-second-area state". Therefore, in a case where the power Wo of the signal output from the variable gain amplifier 7 is subsequently set to the "out-of-second-area state", the set gain is increased when the power Wo is under the "second-lower-limit over state". In a case where the power Wo of the signal output from the variable gain amplifier 7 is under the out-of-second state", the set gain is reduced when the power Wo is under the "second-upper-limit over state".
According to the embodiment 1 described above, the gain is controlled by the first gain control operation AP1 while the gain difference of each control cycle being variable. Therefore, there can be implemented a gain control method in which the gain control speed and the gain control precision required to each control cycle are optimally set.
Furthermore, the gain control precision is enhanced in connection with the repetition of the control cycle in the first gain control operation AP1, and thus there is implemented a gain control method for carrying out gain control at high speed so that the gain to the variable gain amplifier 7 is converged into a predetermined width.
The value of the gain when the power Wo output from the variable gain amplifier 7 is converged to the target power Wd at the previous intermittent reception time can be set to the value of the initial gain Gp0. Therefore, there is implemented a gain control method for carrying out the gain control on the variable gain amplifier 7 at high speed when the reception level is little varied.
Furthermore, there are provided the gain control operation AP1 in which the gain difference in each control cycle is variable, and the gain control operation AP2 which operates after the gain control operation AP1 and in which the gain difference in each control cycle is fixed, so that there is implemented a gain control method for carrying out the gain control at high speed with fixed gain precision.
Furthermore, the gain is controlled with the gain difference of each control cycle being variable by the first gain control operation AP1, and thus there can be implemented a gain control device in which the gain control speed and the gain control precision required to each control cycle are optimally set, or a cellular phone having the gain control device described above.
The gain control precision is enhanced in connection with the repetition of the control cycle in the first gain control operation AP1, and thus there are implemented a gain control device for carrying out the gain control at high speed so that the gain to the variable gain amplifying 7 is converged into a predetermined width, and a receiver and a cellular phone which are equipped with the gain control device.
Furthermore, the value of the gain when the power Wo output from the variable gain amplifier 7 is converged to the target power Wd at the previous intermittent reception time can be set as the value of the initial value Gp0. Therefore, there are implemented a gain control device for carrying the gain control on the variable gain amplifier 7 at high speed when the variation of the reception level is little, and a receiver and a cellular phone which are equipped with the gain control device described above.

Furthermore, there are provided the gain control operation AP1 in which the gain difference in each control cycle is variable, and the gain control operation AP2 which is subsequent to the gain control operation AP1 and in which the gain difference in each control cycle is fixed, and thus there are implemented a gain control device for carrying out the gain control at high speed and with fixed gain precision, and a receiver and a cellular phone which are provided with the gain control device described above.

Embodiment 2

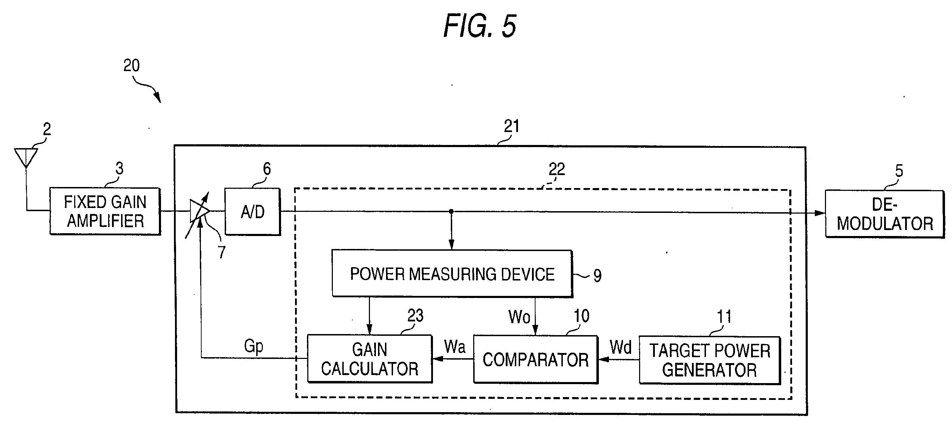

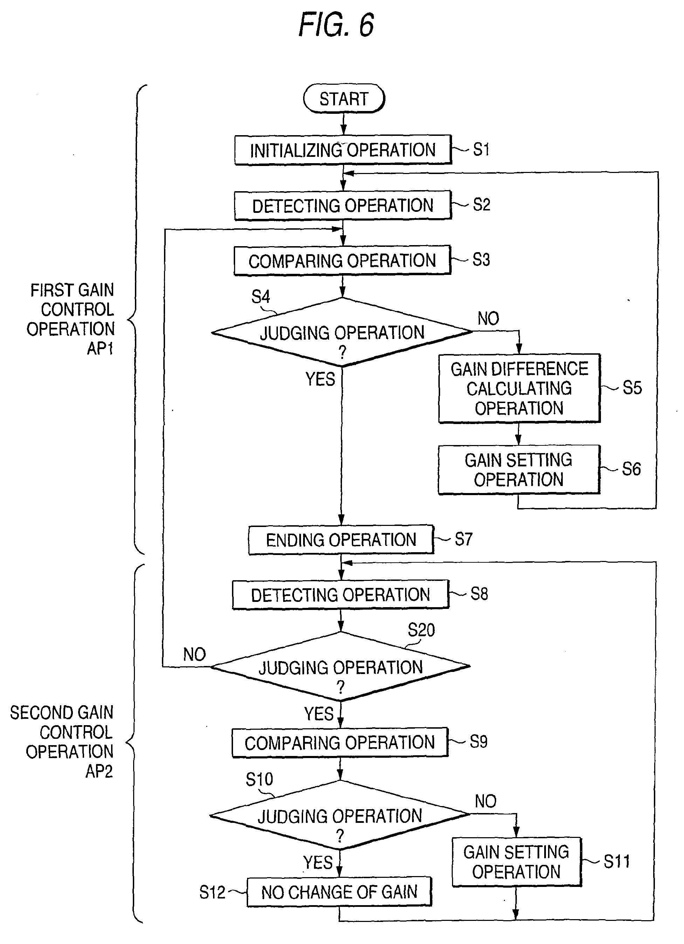

A gain control device and a gain control method which are used in a cellular phone of the embodiment 2 will be described. A receiver 20 which is improved as compared with the embodiment 1 as shown in Fig. 5 is used in the embodiment 2. The receiver 20 has a gain control device 21, and the gain control device 21 has a gain controller 22. The gain controller 22 has a supply loop of measured power Wo from the power measuring device 9 to the gain calculator 23 as compared with the gain controller 8 of Fig. 1. In the embodiment 2, a step S20 for executing a judgment operation is newly added between the steps S8 and S9 of the second gain control operation AP2 in the operation flowchart shown in Fig. 6. A control loop which is returned from the step S20 to the step S3 of the first gain control operation AP1 is added. The other construction is the same as the embodiment 1. The same elements are represented by the same reference numerals, and the description thereof is omitted.

Step S20 is a step of judging whether the power Wo measured by the power measuring device 9 is within a predetermined range. The predetermined range described above is the "first area range" described in the embodiment 1. When it is judged in the judgment step S20 that the measured power Wo is within the first area range, the measured power Wo is estimated to approach to the target power Wd to the extent that the second gain control operation AP2 is carried out. Thereafter, the variable gain amplifier 7 is controlled by the second gain control operation AP2.

When it is judged in the judgment step S20 that the measured power Wo is not within the first area, the measured power Wo is estimated not to approach to the target power Wd to the extent that the second gain control operation AP2 is carried out, and the processing returns from step S20 to step S3 to control the measured power Wo by the first gain control operation AP1. The other operations are the same as the embodiment 1, and thus the description thereof is omitted.

In the embodiment 2 described above, it is possible to perform not only the shift from the first gain control operation AP1 to the second gain control operation AP2 described in the embodiment 1, but also the return from the second gain control operation AP2 to the first gain control operation AP1 by the step S20.

Accordingly, when fading, shadowing and other rapid variation of reception level occur while the variable gain amplifier 7 is controlled by the second gain control operation AP2 and thus it is required to greatly correct the gain set in the variable gain amplifier 7, the variable gain amplifier 7 can be subjected to the gain control again by the first gain control operation AP1.

When the gain control is not quickly carried out on the variable gain amplifier 7, the follow-up performance to an input signal in the variable gain amplifier 7 is lost, and thus a distorted reception signal is output from the variable gain amplifier 7. Therefore, a distorted reception signal may be output from the gain control device 21.

Accordingly, when the gain control is carried out on the variable gain amplifier 7 at high speed, distortion output from the variable gain amplifier 7 is reduced.

According to the embodiment 2, even when the second gain control operation AP2 is operating, the operation can be returned to the first gain control operation AP1 to carry out the gain control operation. Therefore, there can be implemented a gain control method in which the gain control can be carried out on the variable gain amplifier 7 at high speed, and distortion output from the variable gain amplifier 7 is little even when fading, shadowing and other rapid variation of reception level occur while the second gain control operation is carried out.

Furthermore, even when the second gain control operation AP2 is being carried out, the operation can be returned to the first gain control operation AP1 to carry out the gain control operation. Therefore, there can be implemented a gain control method in which the gain control can be carried out on the variable gain amplifier 7 at high speed and distortion output from the variable gain amplifier 7 is little even when fading, shadowing and other rapid variation of reception level occur while the second gain control operation is carried out, and a receiver and a cellular phone which are provided with the gain control device.

Embodiment 3

A gain control device used in a cellular phone according to an embodiment 3 will be described.

The construction of the gain control device 21 is the same as the embodiment 2, and thus the description thereof is omitted.

The gain control operation and the gain control method of the gain control device 21 according to the embodiment 3 will be described with reference to Fig. 6.

In the operation of the gain control device 21 according to the embodiment 3, the predetermined range of the judgment step S20 is set to the dynamic range of the A/D converter 6. The other operations are the same as the embodiment 2, and the description thereof is omitted.

It is assumed that the upper limit of the dynamic range of the A/D converter 6 is set to be above the upper limit of the "first area" described in the embodiment 1. When the power Wo which is not within the dynamic range of the A/D converter 6 is input to the A/D converter 6, the A/D converter 6 does not properly operate, and thus proper demodulation cannot be performed in the demodulator 5 to which a signal output from the A/D converter 6 is input. Furthermore, the value of the power Wo measured in the power measuring device 9 to which a signal output from the A/D converter 6 is input is not proper.

Accordingly, there may occur such a case that the value of the measured power Wo is judged as being within the "first area" although the signal output from the A/D converter 6 actually has a value over the upper limit of the "first area". In such a case, if the power Wo is judged to be within the "first area", the gain of the variable gain amplifier is controlled by the second gain control operation AP2, so that much time is needed to execute the gain control.

Furthermore, the demodulator 5 does not properly operate while no proper power is input from the A/D converter 6 to the demodulator 5.

Accordingly, when the power Wo output from the variable gain amplifier 7 is over the dynamic range of the A/D converter, the state that the demodulator 5 does not properly operate is continued.

Therefore, according to the embodiment 3, when the power Wo output from the variable gain amplifier 7 gets out of the dynamic range of the A/D converter 6 during the period when the gain control is carried out on the variable gain amplifier 7 by the second gain control operation AP2, the gain difference is made variable by the first gain control operation AP1, and the variable gain amplifier 7 is subjected to the gain control, thereby quickly eliminating the state that the demodulator 5 does not properly operate.

Furthermore, the demodulator 5 quickly operates properly, so that the follow-up to an input signal is enhanced, and the distortion of the signal output from the demodulator 5 is suppressed.

According to the embodiment 3, there can be implemented a gain control method in which when the power Wo output from the variable gain amplifier 7 gets out of the dynamic range of the A/D converter 6 during the period when the gain control is carried out on the variable gain amplifier 7 by the second gain control operation AP2, and the variable gain amplifier 7 is subjected to the gain control, thereby quickly eliminating the state that the demodulator 5 does not properly operate.

Furthermore, there can be implemented a gain control method in which the demodulator 5 quickly operates properly, so that the follow-up to an input signal is enhanced, and the distortion of the signal output from the demodulator 5 is suppressed.

Still furthermore, there can be implemented a gain control device in which when the power Wo output from the variable gain amplifier 7 gets out of the dynamic range of the A/D converter 6 during the period when the gain control is carried out on the variable gain amplifier 7 by the second gain control operation AP2, the variable gain amplifier 7 is subjected to the gain control by the first gain control operation AP1, thereby quickly eliminating the state that the demodulator 5 does not properly operate, and a receiver and a cellular phone which are provided with the gain control device described above.

Furthermore, there can be also implemented a gain control device in which the demodulator 5 quickly operates properly, so that the follow-up to an input signal is enhanced, and the distortion of the signal output from the demodulator 5 is suppressed, and also a receiver and a cellular phone which are provided with the gain control device described above.

Embodiment 4

A gain control device used in a cellular phone according to an embodiment 4 will be described.

The construction of the gain control device 21 according to an embodiment 4 is the same as the embodiment 2, and thus the description thereof is omitted.

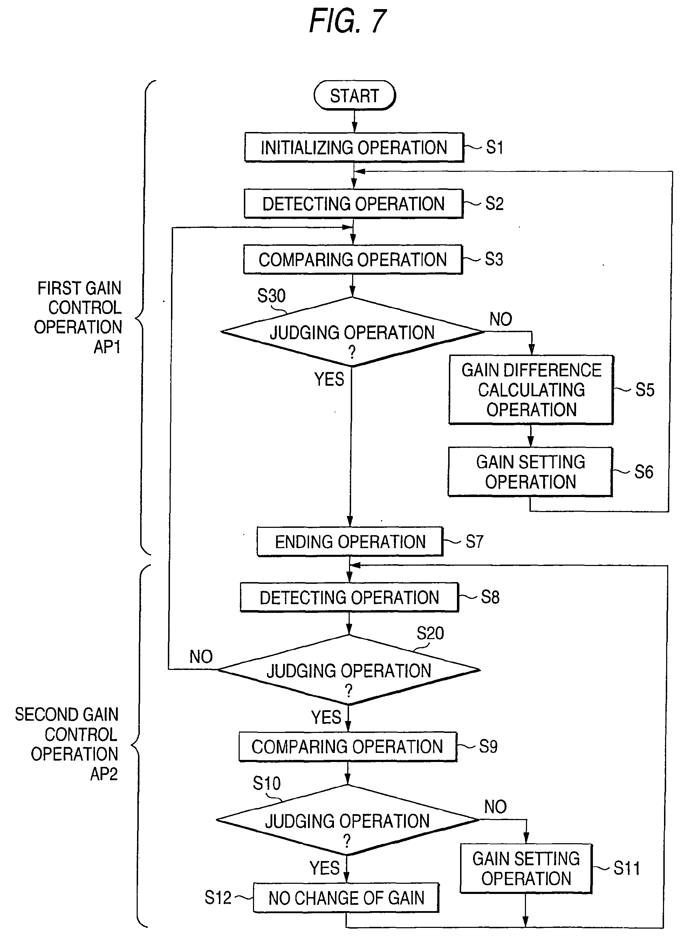

The gain control operation and the gain control method of the gain control device 21 according to the embodiment 4 will be described with reference to Fig. 7. Fig. 7 is a flowchart showing the gain control operation and the gain control method of the gain control device according to the embodiment 4.

Step S30 is a step of executing a judgment in the first gain control operation AP1. Unlike the judgment step S4 used in any of the embodiments 1 to 3, the ending step S7 is started even when the repetitive execution frequency N of the first gain control operation AP1 reaches a predetermined frequency Np.

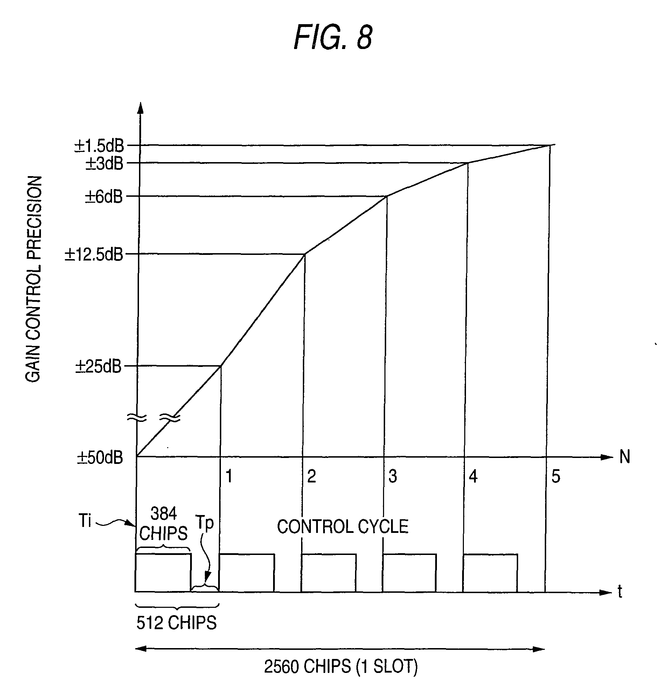

The relationship between the frequency N of the control cycle repeated in the gain control operation AP1 and the gain control precision will be described with reference to Fig. 8.

The upper stage of Fig. 8 shows the relationship between the repetitive frequency N of the gain control cycle and the gain control precision, and the lower stage of Fig. 8 shows an example of a time needed to set the gain in the next gain control cycle when the control cycle of the first gain control operation AP1 is once carried out. In Fig. 8, the time needed to set the gain in the next gain control cycle needs 384 chips as a power integrating time and 512 chips as a calculating and setting time.

As shown in the lower stage of Fig. 8, when it is required that the first gain control operation AP1 is finished by 1 slot (2560 chips), the control cycle of the first gain control operation can be repeated five times at maximum.

As shown in the upper stage of Fig. 8, when the repetitive frequency of the control cycle of the first gain control operation AP1 is four, it can be carried out with the gain control precision range of $\pm 3$dB. When the repetitive frequency of the gain control cycle is five, it can be carried out with the gain control precision range of $\pm 1.5$dB.

As described above, a worker can select the control precision and the control frequency in the first gain control operation AP1 in accordance with an application.

The following is examples of this selection. When the precision of the second gain control operation AP2 is not so high, the worker sets the precision of the first gain control operation AP1 so that the precision is not so high. Furthermore, the worker selects a low frequency Np so that the first gain control operation AP1 is rapidly finished.

When the precision of the second gain control operation AP2 is high, the precision of the first gain control operation AP1 is also enhanced, and Np is set to a large number so that the gain control is carried out excellently enough to execute the second gain control operation AP2 when the second gain control operation AP2 is started.

As described above, by changing Np, the precision or the speed required to the first gain control operation AP1 can be switched.

Furthermore, at the power-on time or the frequency switching time or when there is no information on reception signal level, the predetermined frequency Np is set to a small value. By setting as described above, as the gain control cycle of the second gain control operation AP2 is executed, the first gain control is actually prevented from being unnecessarily repeated although the gain control is executed. Furthermore, when the reception level varies greatly and the second gain control operation AP2 is shifted to the first gain control operation AP1, the predetermined frequency Np is set to a large value. According to the setting described above, the gain control can be executed surely to the extent that the control cycle of the second gain control operation AP2 is executed, and the time for which the control cycle is operated under the "out-of-first-area" can be stably reduced.

According to the embodiment 4, the gain control precision and the gain control frequency of the first gain control device can be arbitrarily selected, and thus an optimal gain control method meeting to various kinds of conditions can be implemented.

Furthermore, the gain control precision and the gain control frequency of the first gain control device can be arbitrarily selected. Therefore, an optimal gain control device meting to various kinds of conditions can be implemented, and also a receiver and a cellular phone which are provided with the gain control device described above can be implemented.

Embodiment 5

A gain control device of a cellular phone according to an embodiment 5 will be described.

The construction of the embodiment 5 is the same as the embodiment 4, etc. , and thus the description thereof is omitted.

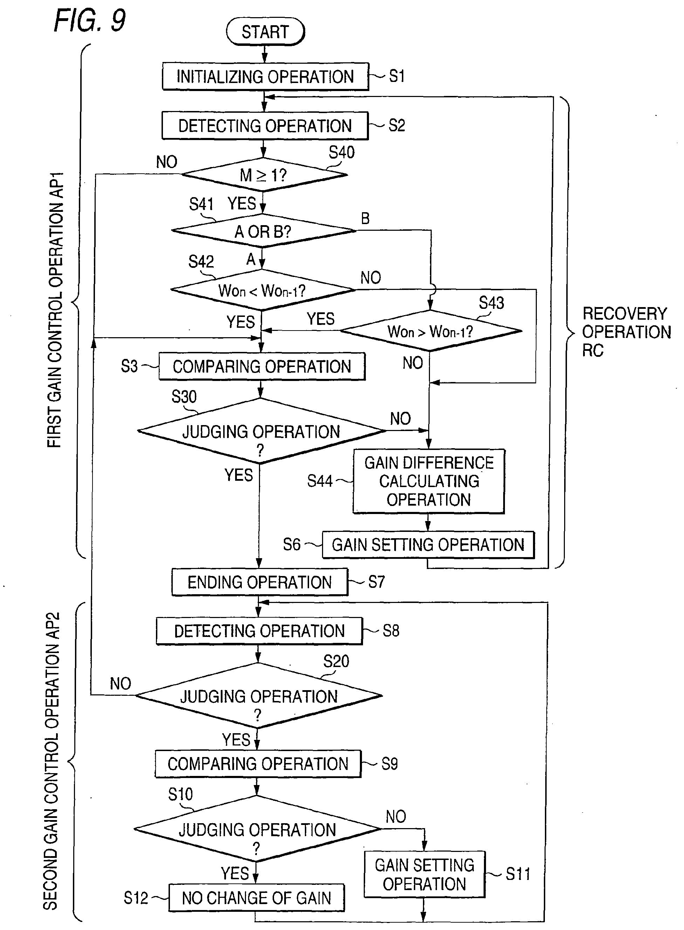

The gain control operation and the gain control method according to the embodiment 5 will be described with reference to Fig. 9. The operation of the gain control device and the cellular phone according to the embodiment 5 is difference from the embodiment 4, etc. in that there is provided a recovery operation RC for controlling the gain variable amplifier 4 so as to converge the output Wo of the gain variable amplifier 7 to the target power Wd when the output Wo of the gain variable amplifier 7 is fixed and it cannot be converged into the target power Wd.

In step S40, it is judged whether the control cycle of the first gain control operation AP1 is carried out once or more. When the first control cycle is carried out in the first gain control operation AP1, it is judged that the frequency at which the control cycle of the first gain control operation AP1 is carried out is equal to zero, and thus the comparison of the comparator 10 is carried out (S3). When the control cycle of the first gain control operation AP1 has been carried out once or more, the judgment step S41 is carried out.

In step S41, it is judged whether the value of the previously set gain difference Gvn-1 is a negative value (A) or positive value (B). When the value of the previously set gain difference Gvn-1 is equal to a negative value (A), a judgment step S42 described later is started. On the other hand, when the value of the previously set gain difference Gvn-1 is equal to a positive value (B), a judgment step S43 described later is started.

In the judgment step S42, it is judged whether the presently measured power Won is smaller than the previously measured power Won-1. If the previously set gain difference is equal to a negative value (A), the presently measured power Won would be smaller than the previously measured power Won-1.

Accordingly, if it is judged in the judgment step S42 that the power Won output from the present A/D converter 6 is smaller than the previously measured power Won-1, the comparing step S3 is carried out.

On the other hand, if it is judged in the judgment step S42 that the present power Won output from the A/D converter 6 is larger than the previously measured power Wo-1, the power Wo thus measured is incorrect. Therefore, a gain difference calculating step S44 is started, and then the gain is set in the variable gain control device 7.

It is judged in the judgment step S43 whether the presently measured power Won is larger than the previously measured power Won-1. If the previously set gain difference is equal to a positive value (B), the presently measured power won would be larger than the previously measured power Won-1.

Accordingly, if it is judged in the judgment step S43 that the power Won output from the A/D converter at present is larger than the previously measured power Won-1, the comparing step S3 is carried out.

On the other hand, if it is judged in the judgment step S43 that the power Won output from the A/D converter 6 at present is smaller than the previously measured power Won-1, the power Wo thus measured is incorrect. Therefore, the gain difference calculating step S44 is started, and then the gain is set in the variable gain control device 7.

Step S44 is a gain difference calculating step used in the embodiment 5, and it is different from the embodiment 4, etc. in that when an instruction is output to execute the previous gain difference calculating operation again in the judgment step S42 or the judgment step S43, the gain difference calculating operation is carried out again.

When an error is found in the embodiment 5, the previous gain difference calculating operation is executed again by executing the gain difference calculating step S44. However, the gain control device may be designed so that the gain control is retried from the start by executing the initializing step S1 when an error is found.

According to the gain control device 4 or 21 of any one of the embodiments 1 to 4, for example when the sign of the gain difference is set to positive, the measured power is output in the same manner as the case where the sign of the gain difference is set to negative because of various kinds of factors, the subsequent operation carries out the gain control on the basis of the erroneous operation concerned, so that it is difficult to converge the power Wo output from the variable gain amplifier 7 to the target power Wd.

A specific example will be described with reference to Fig. 3.

In the first control cycle (1), the gain set to 50(dB) is set to 25(dB) because 25(dB) is subtracted from 50(dB). At this time, when 25(dB) is erroneously added to 50(dB) for an unexpected reason or the like, the gain of 75(dB) is output. Subsequently, the first control cycle is repeated, and the gain difference in the first gain control cycle (2) is equal to 12.5(dB). Therefore, the gain in the first gain control cycle (2) is equal to 62.5(dB). Likewise, the gain difference in the first gain control cycle (3) is equal to 6.3, and the gain in the first gain control cycle (3) is equal to 56.2 (dB). Accordingly, the gain difference is gradually reduced although the target power Wd and the output power are far away from each other. Therefore, much time is needed until the measured power Wo is made equal to the target power Wd.

However, according to the operation like the embodiment 5, even when there is achieved such a result that the measured power is different in sign from an estimated gain difference, the error concerned can be detected, and thus the power Wo output from the variable gain amplifier 7 is liable to be converged to the target power Wd.

Furthermore, according to the operation like the embodiment 5, even when the sign of the gain difference is once incorrect, the error concerned can be detected, and also the gain control may merely carried out from the gain difference calculation operation which has been carried out just before. Therefore, the high-speed gain control is not deteriorated.

According to the embodiment 5, even when there is achieved such a result that the measured power Wo is different in sign from an estimated gain difference, the error can be detected, and thus the gain control on the variable gain amplifier 7 can be retried. Accordingly, there can be implemented a gain control method which can prevent that the power Wo output from the variable gain amplifier 7 is not converged to the target power Wd.

Furthermore, the retry of the gain control on the variable gain amplifier 7 is carried out by merely carrying out the gain control from the gain difference calculating operation which has been carried out just before, and thus there can be implemented a gain control method in which the high-speed gain control is not deteriorated.

Still furthermore, even when there is achieved such a result that the measured power Wo is different in sign from an estimated gain difference, the error can be detected, and thus the gain control on the variable gain amplifier 7 can be retried. Accordingly, there can be implemented a gain control device which can prevent that the power Wo output from the variable gain amplifier 7 is not converged to the target power Wd, and a receiver and a cellular phone which are provided with the gain control device described above.

Still furthermore, the retry of the gain control on the variable gain amplifier 7 is carried out by merely carrying out the gain control from the gain difference calculating operation which has been carried out just before, and thus there can be implemented a gain control device in which the high-speed gain control is not deteriorated, and also a receiver and a cellular phone which are provided with the gain control device described above.

Industrial Applicability

The present invention relates to a gain control device and a gain control method which are used for a receiver.

**Claims**

1. A gain control method for comparing output power of a variable gain amplifier with predetermined target power and controlling the gain of the variable gain amplifier in accordance with a comparison result, wherein plural gain control cycles can be executed while changing the control gain difference thereof.

2. The gain control method according to claim 1, wherein the control gain difference at each gain control cycle is successively reduced in connection with the repetition of the gain control cycle.

3. The gain control method according to claim 1, wherein the control gain difference at each gain control cycle is successively reduced by half in connection with the repetition of the gain control cycle.

4. The gain control method according to claim 3, wherein each gain control cycle includes a gain difference calculating step of calculating the gain difference between the gain set in the variable gain amplifier and a gain which is to be next set, and a gain setting step of setting the gain of the variable gain amplifier in accordance with the calculation result of the gain difference calculating step.

5. The gain control method according to claim 1, further comprising a recovery operation of retrying the gain control when the gain control falls into a state that the gain to the variable gain amplifier cannot be converged into a predetermined control width.

6. The gain control method according to claim 1, wherein the number of the gain control cycles can be set.

7. The gain control method according to any one of claims 1 to 6, wherein the control gain difference is determined as the difference between a gain which has been already set in the variable gain amplifier and a gain which is newly set.

8. The gain control method according to any one of claims 1 to 7, wherein a gain when the output of the variable gain amplifier reaches a predetermined target value in the previous operation of the variable gain amplifier is used as a gain which is initially set in the variable gain amplifier.

9. A gain control method for comparing output power of a variable gain amplifier with predetermined target power and controlling the gain of the variable gain amplifier in accordance with a comparison result, comprising:

   a first gain control operation of executing plural gain control cycles while varying the control gain difference thereof; and
   a second gain control operation of executing plural gain control cycles while the control gain difference thereof is fixed.

10. The gain control method according to claim 9, wherein each gain control cycle of the first gain control operation is executed while varying each gain control difference thereof.

11. The gain control method according to claim 9, wherein the control gain difference at each gain control cycle in the first gain control operation is successively reduced in connection with the repetition of the gain control cycle.

12. The gain control method according to claim 9, wherein the control gain difference at each gain control cycle in the first gain control step is successively reduced by half in connection with the repetition of the gain control cycle.

13. The gain control method according to claim 9, wherein the gain control cycle of the first gain control operation comprises a gain difference calculating step of calculating the gain difference between the gain set in the variable gain amplifier and a gain to be next set, and a gain setting step of setting the gain of the variable gain amplifier in accordance with the calculation result of the gain difference calculating step.

14. The gain control method according to claim 9, further comprises a recovery operation of retrying the gain control when the gain control falls into a state that the gain to the variable gain amplifier cannot be converged into a predetermined control width in the first gain control operation.

15. The gain control method according to claim 9, wherein the number of the gain control cycles in the first gain control operation can be set.

16. The gain control method according to claim 9, wherein after the first gain control operation is finished, the second gain control operation is carried out.

17. The gain control method according to claim 9, wherein during the period when the second gain control operation is carried out, the second gain control operation is switched to the first gain control operation on the basis of a predetermined condition.

18. The gain control method according to claim 17, wherein the second gain control operation includes a judging step of judging on the basis of detected power whether the first gain control operation should be executed or not.

19. The gain control method according to any one of claims 9 to 18, wherein the control gain difference at each gain control cycle in the first gain control operation is determined as the difference between a gain which has been already set in the variable gain amplifier and a gain which is newly set.

20. The gain control method according to any one of claims 9 to 19, wherein in the first gain control operation, a gain when the output of the variable gain amplifier reaches a predetermined target value in the previous operation of the gain amplifier is used as the gain which is initially set in the variable gain amplifier.

21. A gain control device for comparing output power of a variable gain amplifier with predetermined target power and controlling the gain of the variable gain amplifier in accordance with a comparison result, wherein plural gain control cycles can be executed while changing the control gain difference thereof.

22. The gain control device according to claim 21, wherein the control gain difference at each gain control cycle is successively reduced in connection with the repetition of the gain control cycle.

23. The gain control device according to claim 21, wherein the control gain difference at each gain control cycle is successively reduced by half in connection with the repetition of the gain control cycle.

24. The gain control device according to claim 23, wherein the gain control cycle is set to carry out a gain difference calculating step of calculating the gain difference between the gain set in the variable gain amplifier and a gain which is to be next set, and a gain setting step of setting the gain of the variable gain amplifier in accordance with the calculation result of the gain difference calculating step.

25. The gain control device according to claim 21, wherein the gain control contains a recovery operation of retrying the gain control when the gain control falls into a state that the gain to the variable gain amplifier cannot be converged into a predetermined control width.

26. The gain control device according to claim 21, wherein the number of the gain control cycles can be set.

27. The gain control device according to any one of claims 21 to 26, wherein the control gain difference at each gain control cycle is determined as the difference between a gain which has been already set in the variable gain amplifier and a gain which is newly set.

28. The gain control device according to any one of claims 21 to 27, wherein a gain when the output of the variable gain amplifier reaches a predetermined target value in the previous operation of the variable gain amplifier is used as a gain which is initially set in the variable gain amplifier.

29. A gain control device for comparing output power of a variable gain amplifier with predetermined target power and controlling the gain of the variable gain amplifier in accordance with a comparison result, **characterized by** being designed so as to carry out a first gain control operation of executing plural gain control cycles while varying the control gain difference thereof, and a second gain control operation of executing plural gain control cycles while the control gain difference is fixed.

30. The gain control device according to claim 29, wherein the gain control cycles of the first gain control operation are executed while varying each gain control difference thereof.

31. The gain control device according to claim 29, wherein the control gain difference at each gain control cycle in the first gain control operation is successively reduced in connection with the repetition of the gain control cycle.

32. The gain control device according to claim 29, wherein the control gain difference at each gain control cycle in the first gain control operation is successively reduced by half in connection with the repetition of the gain control cycle.

33. The gain control device according to claim 29, wherein the gain control cycle of the first gain control operation is set to carry out a gain difference calculating operation of calculating the gain difference between a gain set in the variable gain amplifier and a gain to be next set, and a gain setting operation of setting the gain of the variable gain amplifier in accordance with the calculation result of the gain difference calculating operation.

34. The gain control device according to claim 29, wherein the first gain control operation contains a recovery operation of retrying the gain control when the gain control falls into a state that the gain to the variable gain amplifier cannot be converged into a predetermined control width in the first gain control operation.

35. The gain control device according to claim 29, wherein the number of the gain control cycles in the first gain control operation can be set.

36. The gain control device according to claim 29, wherein after the first gain control operation is finished, the second gain control operation is carried out.

37. The gain control device according to claim 29, wherein during a period when the second gain control operation is carried out, the second gain control operation is switched to the first gain control operation on the basis of a predetermined condition.

38. The gain control device according to claim 37, wherein the second gain control operation contains a judging step of judging on the basis of detected power whether the first gain control operation should be executed or not.

39. The gain control device according to any one of claims 29 to 38, wherein the control gain difference at each gain control cycle in the first gain control operation is determined as the difference between a gain which has been already set in the variable gain amplifier and a gain which is newly set.

40. The gain control device according to any one of claims 29 to 39, wherein in the first gain control operation, a gain when the output of the variable gain amplifier reaches a predetermined target value in the previous operation of the gain amplifier is used as the gain which is initially set in the variable gain amplifier.

41. A receiver having the gain control device according to any one of claims 21 to 40.

42. A cellular phone having the gain control device according to any one of claims 21 to 40.

*FIG. 1*

# FIG. 2

```
                    ┌─────────┐
                    │  START  │
                    └────┬────┘
                         ▼
        ┌─────────────────────────────┐
        │   INITIALIZING OPERATION    │──── S1
        └──────────────┬──────────────┘
                       ▼
        ┌─────────────────────────────┐
        │    DETECTING OPERATION      │──── S2
        └──────────────┬──────────────┘
                       ▼
        ┌─────────────────────────────┐
        │   COMPARING OPERATION       │──── S3
        └──────────────┬──────────────┘
         S4            ▼
           ◇─────────────────────────◇   NO
            JUDGING OPERATION ? ───────────┐
           ◇─────────────────────────◇     ▼
                   │ YES          ┌──────────────────────┐
                   │              │  GAIN DIFFERENCE     │── S5
                   │              │  CALCULATING         │
                   │              │  OPERATION           │
                   │              └──────────┬───────────┘
                   │                         ▼
                   │              ┌──────────────────────┐
                   │              │   GAIN SETTING       │── S6
                   │              │   OPERATION          │
                   │              └──────────────────────┘
                   ▼
        ┌─────────────────────────────┐
        │    ENDING OPERATION         │──── S7
        └──────────────┬──────────────┘
                       ▼
        ┌─────────────────────────────┐
        │    DETECTING OPERATION      │──── S8
        └──────────────┬──────────────┘
                       ▼
        ┌─────────────────────────────┐
        │   COMPARING OPERATION       │──── S9
        └──────────────┬──────────────┘
         S10           ▼
           ◇─────────────────────────◇   NO
            JUDGING OPERATION ? ───────────┐
           ◇─────────────────────────◇     ▼
                   │ YES          ┌──────────────────────┐
        S12  ┌──────────────────┐ │   GAIN SETTING       │── S11
             │ NO CHANGE OF GAIN│ │   OPERATION          │
             └──────────────────┘ └──────────────────────┘
```

FIRST GAIN CONTROL OPERATION AP1

SECOND GAIN CONTROL OPERATION AP2

FIG. 3

FIG. 4

FIG. 5

EP 1 553 698 A1

# FIG. 6

```
                           ( START )
                               │
                               ▼
                  ┌──────────────────────────┐
                  │ INITIALIZING OPERATION   │──── S1
                  └──────────────────────────┘
                               │
                               ▼
                  ┌──────────────────────────┐
                  │ DETECTING OPERATION      │──── S2
                  └──────────────────────────┘
                               │
                               ▼
                  ┌──────────────────────────┐
                  │ COMPARING OPERATION      │──── S3
                  └──────────────────────────┘
                               │
            S4                 ▼                        NO
              ◇◇◇◇◇◇◇◇◇◇◇◇◇◇◇◇◇◇◇◇◇◇◇◇◇◇◇◇◇────────────┐
              ◇  JUDGING OPERATION ?       ◇            │
              ◇◇◇◇◇◇◇◇◇◇◇◇◇◇◇◇◇◇◇◇◇◇◇◇◇◇◇◇◇            ▼
                       YES     │              ┌──────────────────────────┐
                               │              │ GAIN DIFFERENCE          │──── S5
                               │              │ CALCULATING OPERATION    │
                               │              └──────────────────────────┘
                               │                           │
                               │                           ▼
                               │              ┌──────────────────────────┐
                               │              │ GAIN SETTING OPERATION   │──── S6
                               │              └──────────────────────────┘
                               ▼
                  ┌──────────────────────────┐
                  │ ENDING OPERATION         │──── S7
                  └──────────────────────────┘
                               │
                               ▼
                  ┌──────────────────────────┐
                  │ DETECTING OPERATION      │──── S8
                  └──────────────────────────┘
                               │
      NO                       ▼                  S20
        ◇◇◇◇◇◇◇◇◇◇◇◇◇◇◇◇◇◇◇◇◇◇◇◇◇◇◇◇◇◇◇◇
        ◇  JUDGING OPERATION ?          ◇
        ◇◇◇◇◇◇◇◇◇◇◇◇◇◇◇◇◇◇◇◇◇◇◇◇◇◇◇◇◇◇◇◇
                       YES     │
                               ▼
                  ┌──────────────────────────┐
                  │ COMPARING OPERATION      │──── S9
                  └──────────────────────────┘
                               │
            S10                ▼                        NO
              ◇◇◇◇◇◇◇◇◇◇◇◇◇◇◇◇◇◇◇◇◇◇◇◇◇◇◇◇◇────────────┐
              ◇  JUDGING OPERATION ?       ◇            │
              ◇◇◇◇◇◇◇◇◇◇◇◇◇◇◇◇◇◇◇◇◇◇◇◇◇◇◇◇◇            ▼
                       YES     │              ┌──────────────────────────┐
                               ▼              │ GAIN SETTING OPERATION   │──── S11
        S12 ──┌──────────────────────────┐    └──────────────────────────┘
              │ NO CHANGE OF GAIN        │
              └──────────────────────────┘
```

FIRST GAIN CONTROL OPERATION AP1

SECOND GAIN CONTROL OPERATION AP2

# FIG. 7

```
                        ┌─────────┐
                        │  START  │
                        └────┬────┘
                             ▼
                 ┌──────────────────────┐
                 │ INITIALIZING OPERATION│─── S1
                 └──────────┬───────────┘
                             ▼
                 ┌──────────────────────┐
                 │  DETECTING OPERATION  │─── S2
                 └──────────┬───────────┘
                             ▼
                 ┌──────────────────────┐
                 │  COMPARING OPERATION  │─── S3
                 └──────────┬───────────┘
       S30                   ▼
          ◇─────────────────────────────◇      NO
          │      JUDGING OPERATION       │──────────┐
          ◇             ?               ◇          ▼
                       YES              ┌────────────────────┐
                        │               │  GAIN DIFFERENCE   │─── S5
                        │               │    CALCULATING     │
                        │               │     OPERATION      │
                        │               └─────────┬──────────┘
                        │                          ▼
                        │               ┌────────────────────┐
                        │               │   GAIN SETTING     │─── S6
                        │               │    OPERATION       │
                        │               └─────────┬──────────┘
                        │                          │
                        ▼                          │
              ┌──────────────────┐                 │
              │ ENDING OPERATION │─── S7           │
              └────────┬─────────┘                 │
                        ▼                          │
              ┌──────────────────┐                 │
              │ DETECTING        │─── S8           │
              │ OPERATION        │                 │
              └────────┬─────────┘                 │
                        ▼        S20               │
      NO      ◇─────────────────────────◇          │
     ┌────────│   JUDGING OPERATION     │          │
     │        ◇           ?            ◇          │
     │                   YES                       │
     │                    ▼                        │
     │        ┌──────────────────────┐             │
     │        │  COMPARING OPERATION  │─── S9       │
     │        └──────────┬───────────┘             │
     │    S10             ▼                         │
     │      ◇─────────────────────────◇    NO       │
     │      │   JUDGING OPERATION     │─────┐       │
     │      ◇           ?            ◇     ▼       │
     │                 YES          ┌──────────────┐│
     │                  ▼           │ GAIN SETTING │─── S11
     │ S12 ┌────────────────────┐   │  OPERATION   ││
     │     │ NO CHANGE OF GAIN  │   └──────┬───────┘│
     │     └──────────┬─────────┘          │        │
     │                │                    │        │
```

**FIRST GAIN CONTROL OPERATION AP1**

**SECOND GAIN CONTROL OPERATION AP2**

# FIG. 8

# FIG. 9

**INTERNATIONAL SEARCH REPORT**

International application No.

PCT/JP02/08362

A. CLASSIFICATION OF SUBJECT MATTER
Int.Cl⁷ H03G3/30

According to International Patent Classification (IPC) or to both national classification and IPC

B. FIELDS SEARCHED

Minimum documentation searched (classification system followed by classification symbols)
Int.Cl⁷ H03G3/30

Documentation searched other than minimum documentation to the extent that such documents are included in the fields searched
Jitsuyo Shinan Koho          1922–1996   Toroku Jitsuyo Shinan Koho   1994–2002
Kokai Jitsuyo Shinan Koho    1971–2002   Jitsuyo Shinan Toroku Koho   1996–2002

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 10-65470 A  (NEC Corp.), 06 March, 1998 (06.03.98), | 1-4,6,7, 21-24,26,27 |
| Y | Page 3, right column, line 6 to page 4, right column, line 27; Figs. 1, 2 & US 5917372 A | 5,8,9-20, 25,28,29-42 |
| | JP 4-117011 A  (NEC IC Miconsystem Kabushiki Kaisha), 17 April, 1992 (17.04.92), | |
| X | Page 5, upper left column, line 19 to upper right column, line 20; Fig. 4 | 1,2,4,7,21, 22,24,27 |
| Y | Page 3, upper left column, line 7 to upper right column, line 10; Figs. 5(a), 5(b) (Family: none) | 9-20,29-42 |

[X]  Further documents are listed in the continuation of Box C.          [ ]  See patent family annex.

| | |
|---|---|
| *    Special categories of cited documents:<br>"A"  document defining the general state of the art which is not considered to be of particular relevance<br>"E"  earlier document but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>   19 November, 2002 (19.11.02) | Date of mailing of the international search report<br>    03 December, 2002 (03.12.02) |
|---|---|
| Name and mailing address of the ISA/<br>    Japanese Patent Office | Authorized officer |
| Facsimile No. | Telephone No. |

Form PCT/ISA/210 (second sheet) (July 1998)

# EP 1 553 698 A1

**INTERNATIONAL SEARCH REPORT**

| International application No. |
|---|
| PCT/JP02/08362 |

**C (Continuation). DOCUMENTS CONSIDERED TO BE RELEVANT**

| Category* | Citation of document, with indication, where appropriate, of the relevant passages | Relevant to claim No. |
|---|---|---|
| X | JP 2001-332984 A (Matsushita Electric Industrial Co., Ltd.), 30 November, 2001 (30.11.01), Full text; Figs. 1 to 7 (Family: none) | 1-4,6,7, 21-24,26,27 |
| Y | JP 4-351005 A (Kokusai Electric Co., Ltd. et al.), 04 December, 1992 (04.12.92), Full text; Figs. 1 to 5 (Family: none) | 5,14,25,34 |
| Y | WO 98/10514 A1 (Mitsubishi Electric Corp.), 12 March, 1998 (12.03.98), Page 2, Claim 2; page 3, Claim 7 & CN 1201566 A   & EP 0859462 A1 & JP 10-512448 A   & US 6167244 A | 5,14,25,34 |
| Y | JP 5-198090 A (Sony Corp.), 06 August, 1993 (06.08.93), Page 3, right column, lines 3 to 7 (Family: none) | 8,20,28,40 |
| Y | JP 9-18260 A (Oki Electric Industry Co., Ltd.), 17 January, 1997 (17.01.97), Page 6, right column, line 8 to page 8, left column, line 16 (Family: none) | 17,18,37,38 |
| Y | JP 10-247856 A (Ford Motor Co.), 14 September, 1998 (14.09.98), Page 3, right column, lines 33 to 49 & EP 0856942 A2   & US 5930693 A | 17,18,37,38 |

Form PCT/ISA/210 (continuation of second sheet) (July 1998)

29